Europäisches Patentamt

European Patent Office

Office européen des brevets

(19)

(11) Publication number: **0 305 202**
**A2**

## (12) EUROPEAN PATENT APPLICATION

(21) Application number: **88307935.2**

(51) Int. Cl.⁴: **C 23 C 14/24**

(22) Date of filing: **26.08.88**

(30) Priority: **28.08.87 GB 8720415**

(43) Date of publication of application:
**01.03.89 Bulletin 89/09**

(84) Designated Contracting States:
**CH DE FR GB IT LI**

(71) Applicant: **VG INSTRUMENTS GROUP LIMITED**
**29 Brighton Road**
**Crawley West Sussex RH10 6AE (GB)**

(72) Inventor: **Lovis, Gordon David**
**3 The Woodlands**
**Hastings East Sussex (GB)**

(74) Representative: **Tomlinson, Kerry John et al**
**Frank B. Dehn & Co. European Patent Attorneys Imperial**
**House 15-19 Kingsway**
**London WC2B 6UZ (GB)**

(54) **Vacuum evaporation and deposition.**

(57) A method of evaporating a source material, and a vapor source assembly (2) for carrying out said method, comprising heating and evaporating said source material (48) and providing a hearth (21) having a downwardly tapering supporting surface (61), preferably concave and substantially conical, with the source material spaced apart from the bottom of the hearth. The method and source assembly are suitable for the processing of materials which melt and form a preferably substantially spherical molten droplet, and also for materials which sublime and are provided in a substantially spherical form. Prior need for sweeping a charged particle flux across source material is avoided, focusing is less critical than for prior sources, and contamination of source materials is reduced.

FIG. 3.

EP 0 305 202 A2

## Description

## VACUUM EVAPORATION AND DEPOSITION

This invention relates to apparatus for the evaporation of materials and the deposition of evaporated material onto substrates under vacuum conditions.

Systems for the deposition of material under vacuum conditions may comprise vapor sources in which source material is evaporated, or sublimed, by the action of electron beams. Such vacuum deposition systems are important in the manufacture of thin films typically for semiconductor devices or optical coatings. The technique is described in United States Patent No.4516525, for example.

In typical vapor sources the source material is disposed within a crucible, or hearth, and an electron flux is directed onto it by the action of electric or magnetic fields. It is generally necessary to provide means to control the position of impact of the electron flux in order to compensate for the change in level of the source material as evaporation proceeds, and thereby to maximise the use of source material. United States Patent No.3883679, for example, describes a vapor source in which the electron beam is guided magnetically and which has magnetic shielding to enhance beam control. Known sources may also comprise means to sweep an electron beam across the source material, as described in United States Patent 4064352 in order to increase the irradiated surface area. It is known that if a beam is maintained stationary on the source material that material may then heat and melt only locally, and a beam may drill through a piece of material at one point, giving poor utilisation of the source material and potentially damaging the hearth and other components of the source assembly. This may be caused at least in part by heat loss from the source material to the hearth which prevents the material from reaching a uniformly high temperature if the beam is not swept across the material. Vapor sources, and related vacuum apparatus, have been reviewed by IE Morichev et al in the Soviet Journal of Optical Technology, volume 43, number 10, 1976, pages 616 to 628. Morichev et al describe arrangements for electron beam control and focusing in several types of source; they also discuss the problems of contamination by materials of the vapor source structure.

In summary, known vapor source assemblies have disadvantages such as contamination of the source material and also that they necessarily comprise means for controlling the electron flux which add to the complexity and cost of the apparatus.

It is therefore an object of this invention to provide an improved method for evaporating source material. It is also an object of the invention to provide a vapor source assembly which is simpler in construction and operation than known vapor sources, and in which the utilisation of source material is improved over known vapor sources, and to provide a vapor deposition system incorporating such an improved vapor source assembly.

According to one aspect of the invention, there is provided a method of evaporating a source material comprising providing a hearth having a downwardly tapered supporting surface with an axis of rotational symmetry, introducing into said hearth an amount of source material, and heating and evaporating the source material, the supporting surface being shaped and the amount of material being selected such that the source material forms a molten droplet which is supported by said supporting surface and spaced apart from the bottom of the hearth.

In this method the droplet of molten source material may make contact with the hearth over substantially only a line, e.g. a circular line, and so heat loss from the material may be controlled to a low level. This allows the droplet to remain molten even with only local heating. Preferably the material is heated by the action of a flux of charged particles, preferably electrons, directed downwardly and generally along said axis. The method may alternatively comprise heating said source material by some other source such as a radiant heater or laser for example.

Because the supporting surface is downwardly tapered and rotationally symmetrical, as the droplet of material evaporates and becomes smaller it moves down the supporting surface whilst remaining centred on the axis. Moreover, with the low heat loss, a generally axially-directed particle beam remains effective to heat the droplet and no means need be provided for adjusting or sweeping the beam. Thus the invention allows the provision of a very simple and effective vapor source assembly. A further advantage of the invention is that, by minimising the area of contact between the source material and hearth, a pathway along which impurities may travel from the hearth to the source material is minimised and hence contamination of the source material is minimised.

The method preferably comprises allowing said source material to adopt a substantially spherical shape under the action of natural cohesive forces, and conveniently comprises selecting an amount of said source material wherein the cohesive force of surface tension, which tends to maintain the source material in a substantially spherical shape, overcomes the force of gravity which tends to distort the source material from that shape. In a preferred embodiment the method comprises supporting a substantially spherical mass of molten source material by a concave, substantially conical hearth.

According to another aspect, the invention provides a vapor source assembly comprising: a concave and substantially conical hearth having a downwardly tapered supporting surface; a mass of source material supported by said supporting surface; means for producing and directing a flux of charged particles at said mass of source material thereby heating and evaporating said source material; in which said mass of source material is substantially spherical, and is spaced apart from the bottom of said hearth.

For suitable materials, those which melt rather than sublime, the source material is melted by the flux of charged particles (preferably electrons) and adopts a substantially spherical shape when molten. The source material may conveniently be introduced into the vapor source assembly when in solid form, in a substantially spherical shape. The invention is especially advantageous for source materials which substantially do not wet the supporting surface; in such materials there are cohesive forces, between neighbouring atoms of the molten material, which are greater than forces of adhesion between atoms of the molten material and atoms which constitute the supporting surface. The vapor source assembly is particularly advantageous for producing vapors from source materials such as aluminium, copper, silicon and niobium. The supporting surface of the hearth is typically composed substantially of copper or molybdenum, or alternatively carbon; for example, the hearth may be composed of copper of molybdenum; or as further examples, a carbon liner may be inserted into a copper or molybdenum hearth. Moreover, a substantially chemically inert liner may be applied to the supporting surface; typically a boron nitride liner is applied by spraying onto the surface. Means for cooling the hearth, preferably by cooling water, may also be provided.

In a preferred embodiment the vapor source assembly comprises a heated filament for producing a flux of electrons, and means to generate an electric field to direct the electrons towards the source material. Preferably the vapor source assembly comprises an electrically conductive cage within which are disposed the hearth and the filament, wherein the filament is fixed in position relative to the cage, and means are provided to move the filament and cage relative to the hearth, or alternatively to move the hearth relative to the filament and cage. Means are provided to apply a potential difference between the filament and cage on the one hand, and the hearth on the other hand, whereby electrons released from the filament are accelerated and directed towards the hearth. The source assembly may also comprise further members to shape the electric field: typically there is provided a filament shield disposed between the filament and hearth, which prevents line-of-sight travel of electrons to the hearth; preferably electrons travel from the filament to the source material along arcuate paths under the action of the electric field. The paths of the electron flux may be adjusted, as will be described later in the specification, by adjusting the position of the cage and filament relative to the hearth.

Alternatively the vapor source assembly may comprise means to generate a magnetic field for directing the electrons towards the source material.

A significant advantage of the present invention is that with the novel geometry of hearth and of source material a more efficient evaporation and usage of source material is achieved without the need to provide means for sweeping the electron flux across it. Also the criteria for focusing are found to be less critical than in prior sources, and we have found that little or no adjustment of the focus is needed during operation, once initially set up.

The selection of the amount of source material is influenced by the mass limit beyond which the material will not remain in a substantially spherical shape, and also in a practical embodiment by the requirements of the amount needed for deposition and a practical size of source assembly. The limit on amount of material can be assessed by considering that the material will naturally adopt the shape with the lowest overall potential energy. Surface tension gives rise to a surface potential energy which is proportional to surface area, and under the influence of this alone the material will become spherical with a radius r. The surface potential energy area is thus proportional to $r^2$, because of its dependence upon surface area. The material also has a gravitational potential energy due to its weight, and this is proportional to density and volume, and hence to $r^3$. Hence, as r increases, the influence of gravity increases over that of surface tension. Preferably the source material has a mass m substantially no greater than an amount equal to $4\Pi R_c{}^3 D/3$, where D is the density of molten source material and $R_c$ is the critical radius at which the weight of the material has a greater influence over its shape than does the surface tension.

It is convenient to define a critical amount of source material as: the maximum amount of source material which will form a substantially spherical shape when molten. The size of the hearth may be greater than that which could support or contain the critical amount of source material, and means may be provided to measure the amount of source material. However, it is particularly convenient to provide a substantially conical hearth of a size which is insufficient to either support or contain an amount of source material greater than the critical amount. Preferably the hearth is a cone with a half angle, at the apex of the cone, in the approximate range from 30° to 50°. The source assembly may comprise an amount of source material which is less than the critical amount, for example we have found it especially convenient to provide an amount of source material occupying an initial volume of approximately 65 mm³ when molten, contained in a hearth of approximate volume 195 mm³, and half angle approximately 40°. This configuration is convenient for evaporating aluminium, copper, silicon or niobium. We have found that the cone contains less than the critical amount for these materials. The critical amount may be influenced by such factors as the formation of oxide layers on the source material, and the interaction between the source material and the supporting surface of the hearth, and hence for evaporating certain materials the optimum dimensions of the source material and hearth may differ from the illustrative example quoted above. Commonly the critical amount of source material will be determined empirically.

According to another aspect there is provided a method of evaporating a source material, comprising: providing a concave and substantially conical hearth having a downwardly tapered supporting surface with an axis of rotational symmetry; introducing into the hearth a substantially spherical amount of the source material in solid form, so as to be supported by the supporting surface, spaced apart from the bottom of the hearth, and making contact with the supporting surface over substantially only a circular line; and directing a flux of charged particles, preferably electrons, generally downwardly towards the material, thereby heating and evaporating the material. The source material may be evaporable by sublimation, and although such material will not melt, and may not retain a spherical shape as evaporation proceeds, the method still has the advantages of low heat loss from the material to the hearth and a low area of contact through which impurities may travel from the hearth to the material.

Also, in a preferred embodiment, said source material of said vapor source assembly is evaporable by sublimation and is heated and consequently evaporated by the action of the charged particle flux.

The invention may also provide a vapor deposition system comprising a vacuum enclosure in which is disposed a substrate and at least one of the vapor source assemblies defined above. Moreover such a system may comprise a plurality of such vapor source assemblies, or hearths thereof, with the advantages of either increasing the available amount of one source material, or providing several source materials for deposition.

A preferred embodiment of the invention will now be described in greater detail by way of example and with reference to the figures in which:

Figure 1 illustrates an amount of source material supported on a hearth;

Figure 2 illustrates a vapor deposition system comprising a vapor source assembly according to the invention; and

Figure 3 illustrates the vapor source assembly in greater detail.

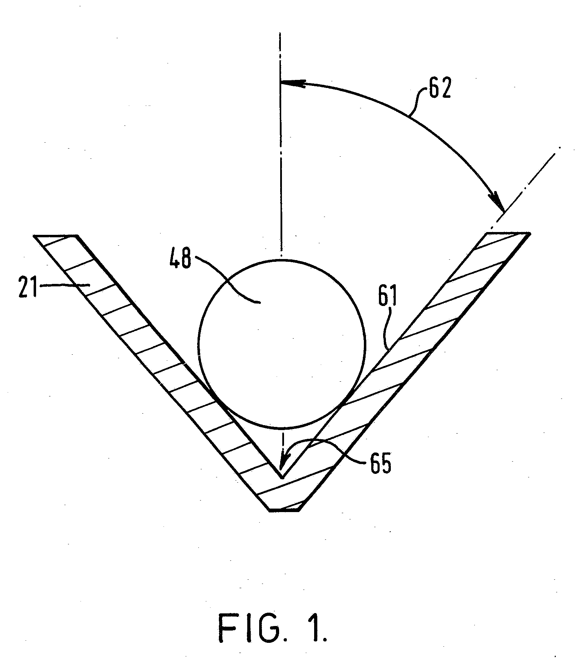

Referring first to figure 1 an amount of source material 48 is supported on a (downwardly tapering) supporting surface 61 of a concave conical hearth 21, spaced apart from the bottom 65 of the hearth. The half-angle 62 of the hearth 21 is approximately 40°. In the preferred embodiment, hearth 21 is composed of copper and supporting surface 61 is coated with boron nitride. The boron nitride is advantageous, in inhibiting reaction between source material 48 and the material of hearth 21, particularly for source materials such as aluminium, copper or gold, although it is not essential to the operation of the vapor source and may be unnecessary for some materials (such as when using a carbon lined hearth for example).

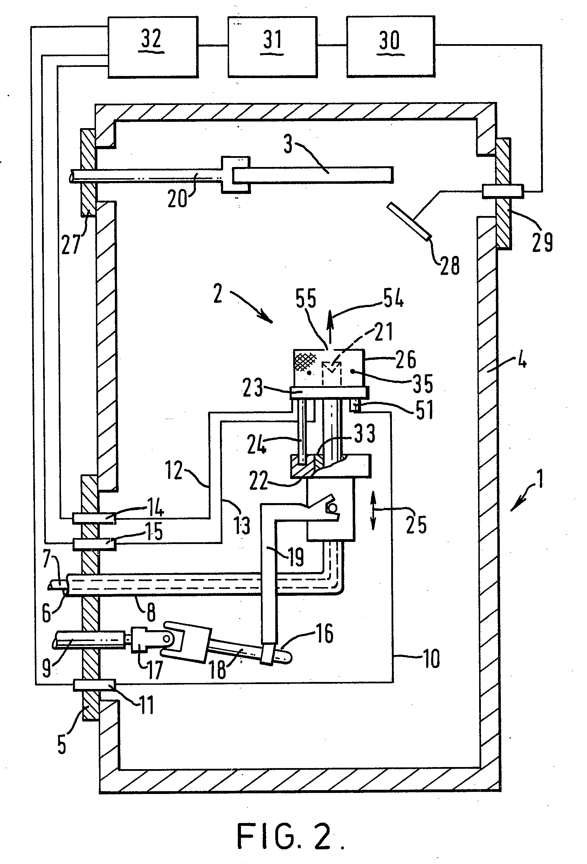

Referring next to figure 2, there is shown in schematic form a vapor deposition system 1 comprising a vapor source assembly 2 and a substrate 3 disposed within a vacuum enclosure 4. The vapor source 2 is conveniently mounted on a mounting flange 5 through which pass: a cooling-water supply 6 comprising coaxial pipes 7 and 8; a manipulator arm 9; a high tension lead 10, via a feedthrough 11, and filament supply leads 12 and 13 via feedthroughs 14 and 15. The arm 9 is part of a manipulator 16 which also comprises members 17, 18 and 19. A second manipulator 20 is provided to hold the substrate 3, and is mounted on a flange 27.

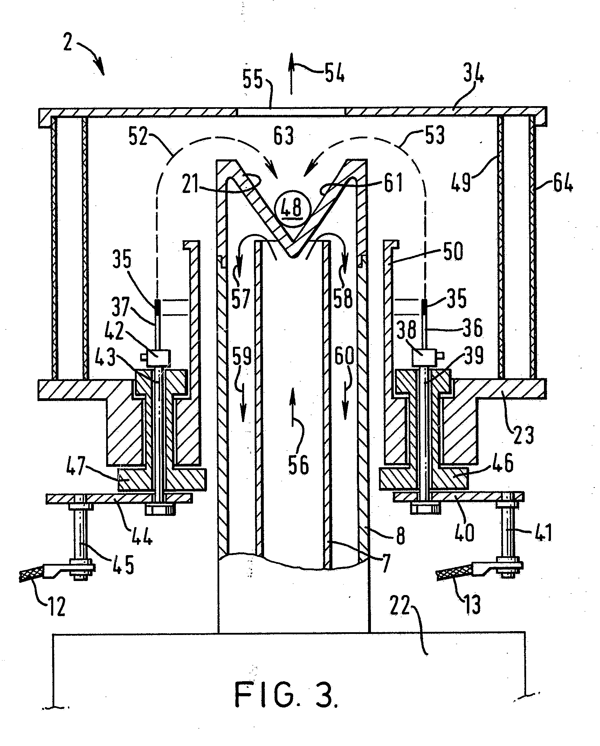

Vapour source assembly 2 comprises a hearth 21 mounted on water pipe 8. Pipe 8 passes through a sleeve 22, and three insulating members are provided to connect sleeve 22 to a platform 23; one such insulating member 24 is shown on figure 2, the other two are similarly disposed; the three are disposed at approximately 120° intervals around the perimeter of sleeve 22. Manipulator 16 may be used to move sleeve 22 as indicated by an arrow 25 and in this way sleeve 22 is moved relative to pipe 8 and hence platform 23 is moved relative to hearth 21. A bush 33 provides a bearing between sleeve 22 and pipe 8. Also shown are a cage 26, and a section through a filament 35 which is disposed circumferentially around hearth 21; these components are described more fully later in the specification with reference to figure 3. Vaporised material 54 leaves source assembly 2 through an exit hole 55 as shown.

Also provided is a film thickness monitor comprising a sensor 28, mounted on a flange 29, and an analyser 30. A controller 31 controls the vapor source assembly 2 via a power supply 32, in response to the output of the film thickness monitor. It will be appreciated that the apparatus also comprises such vacuum pumps and associated equipment for maintaining high or ultra high vacuum conditions as required within enclosure 4.

Referring next to figure 3 there is shown a section through vapor source assembly 2 drawn at approximately 90° to the illustration in figure 2. In this view there are shown again: tube 7, tube 8, hearth 21, platform 23, filament leads 12 and 13, and part of sleeve 22. This view shows how filament 35 is edge welded at two points to two conductive supports 36 and 37. Support 36 is electrically connected via connectors and pillars 38, 39, 40 and 41 to filament lead 13, and support 37 is similarly connected via connectors and pillars 42, 43, 44 and 45 to filament lead 12. Ceramic insulators 46 and 47 insulate pillars 39 and 43, and hence filament 35, from platform 23. The cage 26 (figure 2) comprises an outer screen grid 64, an inner screen grid 49, and a screen plate 34, which has exit hole 55 as shown.

Also shown on figure 3 is a filament shield 50, which along with screens 49, 64 and 34 is electrically connected to platform 23. In operation a voltage of approximately -10kV (with respect to earth) is applied to platform 23, by lead 10 and a connecting member 51 (figure 2). Filament 35 is also biased by approximately -10kV with respect to earth, and is heated by a current of approximately 20A applied through leads 12 and 13. Hearth 21, being in contact with pipe 8 (made of stainless steel) is substantially at earth potential. The source material 48 which is to be evaporated is disposed within hearth 21 as shown. The applied voltage creates an electric field which deflects an electron flux 63 towards source material 48, along arcuate paths such as are indicated by paths 52 and 53. Vapour 54, produced by evaporation or sublimation of material 48 passes out of the vapor source assembly 2 through hole 55 in screen 34. Hearth 21 is cooled by cooling-water which flows via pipe 7 and pipe 8 as indicated by arrows 56 to 60.

In operation electron flux 63 is focused initially upon material 48 by using manipulator 16 to alter the position of platform 23 and hence of filament 35 and cage 26 with respect to hearth 21 and material 48. We have found that with the hearth manufactured according to the invention there is subsequently no need to substantially alter the focusing during operation of vapor source 2. Because the hearth is rotationally symmetrical, as the spherical mass of source material is consumed it remains positioned on the axis of symmetry but moves downwardly whilst remaining in substantially line contact with the hearth and spaced apart from the bottom of the hearth. Heat loss is thereby substantially minimised. Source materials which melt (rather than sublime) remain molten without the need for sweeping, or adjusting the focusing, of the electron flux. Such materials adopt, or remain in, a substantially spherical shape substantially throughout the evaporation process. A low heat loss is also advantageous in vaporising source materials which sublime, such as chromium or tellurium. A further advantage in maintaining substantially line contact is that it provides only a small path for contaminants to pass from the hearth and supporting surface to the source material.

**Claims**

1. A method of evaporating a source material comprising providing a hearth having a downwardly tapered supporting surface with an axis of rotational symmetry, introducing into said hearth an amount of source material, and heating and evaporating said source material, said supporting surface being shaped and said amount of material being selected such that said source material forms a molten droplet which is supported by said supporting surface and spaced apart from the bottom of said hearth.

2. A method as claimed claim 1 in which said droplet of molten source material makes contact with said hearth over substantially only a line.

3. A method as claimed in claim 1 or claim 2 and comprising selecting said amount of source material such that said source material forms a substantially spherical molten droplet, and supporting said droplet by a concave, substantially conical hearth.

4. A method of evaporating a source material, comprising: providing a concave and substantially conical hearth having a downwardly tapered supporting surface with an axis of rotational symmetry; introducing into said hearth a substantially spherical amount of said source material in solid form so as to be supported by said supporting surface, spaced apart from the bottom of said hearth, and making contact with said supporting surface over substantially only a circular line; and heating and evaporating said material.

5. A method as claimed in claim 4 wherein said source material is evaporable by sublimation.

6. A method as claimed in any previous claim and comprising heating and evaporating said source material by directing a flux of charged particles towards said source material, substantially downwardly and generally along said axis.

7. A vapor source assembly comprising: a concave and substantially conical hearth having a downwardly tapered supporting surface; a mass of source material supported by said supporting surface; means for producing and directing a flux of charged particles at said mass of source material thereby heating and evaporating said source material; in which said mass of source material is substantially spherical, and is spaced apart from the bottom of said hearth.

8. A vapor source assembly as claimed in claim 7 in which said source material is melted by said flux of charged particles and adopts a substantially spherical shape when molten.

9. A vapor source assembly as claimed in claim 8 in which said molten source material substantially does not wet said supporting surface.

10. A vapor source assembly as claimed in claim 7 in which said source material is evaporable by sublimation and is heated, and consequently evaporated, by said flux of charged particles.

11. A vapor source assembly as claimed in any of claims 7 to 10 in which said source material makes contact with said supporting surface over substantially only a line.

12. A vapor source assembly as claimed in any of claims 7 to 11 in which said substantially conical hearth has a half angle, at the apex of the cone, substantially in a range of from 30° to 50°.

13. A vapor deposition system comprising a vacuum enclosure and disposed therein at least one vapor source assembly according to any of claims 7 to 12 and also a substrate towards which said evaporated source material is directed.

FIG. 1.

FIG. 2.

FIG. 3.